# EUROPEAN PATENT SPECIFICATION

(11) **EP 1 547 211 B1**
(45) Date of publication and mention of the grant of the patent: **10.04.2013**
(21) Application number: 03758298.8
(22) Date of filing: 03.10.2003
(51) Int. Cl.: H01S 3/13, H01S 5/0687

(54) **FREQUENCY STABILIZED LASER SYSTEM COMPRISING PHASE MODULATION OF BACKSCATTERED LIGHT**
FREQUENZSTABILISIERTER LASER MIT PHASENMODULIERTEM RÜCKGESTREUTEM LICHT
SYSTEME LASER A FREQUENCE STABILISEE COMPRENANT UNE MODULATION DE PHASE DE LUMIERE RETRODIFFUSEE

(30) Priority: 04.10.2002 GB 0222944
(43) Date of publication of application: 29.06.2005
(73) Proprietor: Renishaw plc, Wotton-Under-Edge Gloucestershire GL12 8JR (GB)
(72) Inventor: CHAPMAN, Mark, Adrian, Vincent, Gloucestershire GL12 7SB (GB); LEE, William, Ernest, Bristol, Bristol BS5 6YA (GB); ANGOOD, Stephen, Mark, Stroud, Gloucestershire GL6 8NB (GB); CHANEY, Raymond, John, Berkeley, Gloucestershire GL13 9SF (GB)
(74) Representative: Fowler, Maria Jayne
(86) International application number: PCT/GB2003/004340
(87) International publication number: WO 2004/032294

(56) References cited:
- EP-A- 0 258 665
- EP-A- 0 840 468
- US-A- 4 815 806
- US-A- 5 535 003
- US-A- 5 818 857
- PATENT ABSTRACTS OF JAPAN vol. 012, no. 003 (E-570), 7 January 1988 (1988-01-07) -& JP 62 162381 A (FUJITSU LTD), 18 July 1987 (1987-07-18)

## Description

This invention relates to a laser system and in particular to frequency stabilised laser systems.

A problem encountered when using optical components with a laser system is back scattering. This is particularly so when a frequency stabilised laser is being utilised. Such a laser system may be frequency stabilised by balancing the intensity of its two orthogonally polarised output modes. Alternative methods are to use the Lamb dip for a single mode laser or to monitor the beat frequency between the two modes of a dual mode laser. If the modes are not balanced, then, for example, a heater circuit is employed to control the length of the laser tube and thus the frequency of the emergent laser beam.

One way to obtain samples of the two polarisation states is to split the laser beam into two sub-beams, one of each polarisation state for example, by a birefringent prism. Portions of each sub-beam are then diverted to photodiodes for intensity comparison. An alternative method is to use a glass plate which produces a reflected beam at each surface, the reflected beams pass through orthogonal Polaroids to select the appropriate mode from the laser for intensity measurement and comparison. A heater circuit which controls the temperature of the laser source responds to changes in the ratio of the intensity of the two orthogonal polarisation states of the laser beam measured by the photodiodes.

In US 5,535,003 an apparatus to stabilize the wavelength of a light source is disclosed which uses a phase comparator in a feedback loop to a heater circuit. The phase of two fringe scans derived from different optical path lengths in a two-beam interferometer is matched or the difference is maintained by the phase comparator.

Any optical components for example, a lens, prism or fibre optic coupling which are further along the beam path than the photodiodes can introduce back reflections which will interfere with the portions of the sub-beams which have been diverted to the photodiodes and the light within the laser tube.

The magnitude of the interference within each sub beam will vary depending on the amount and direction of back-scattered light associated with each sub-beam. This produces an imbalance in the measured intensity registered by the photodiodes which causes destabilisation of the laser as the heater circuit compensates for an apparent imbalance between the intensities of the two sub-beams.

US 4,815,806 discloses an optical reflector, the position of which can be varied by translating it relative to the laser, in order to vary the optical path length and decrease the likelihood that an interfering standing wave will be established.

According to the present invention there is provided a laser system according to claim 1.

The invention will now be described by way of example with reference to the accompanying drawings, of which:
Fig 1 shows schematically a view of a fibre optic system;
Fig 2 is a cross-sectional view of an embodiment of the invention;
Fig 3 is a cross-sectional view of an alternative embodiment of the invention;
Figs 4a and 4b are cross-sectional views of further embodiments of the invention;
Fig 5 shows schematically a view of a laser interferometer system;
Fig 6 is a cross-sectional view of a further embodiment of the invention; and
Fig 7 shows schematically a laser interferometer according to the invention.

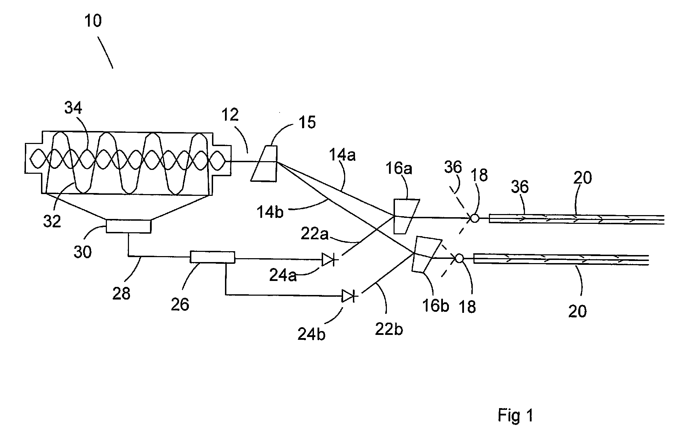

Fig 1 shows a laser source 10 which produces a laser beam 12. The laser beam 12, is split by a birefringent prism 15 into two orthogonally polarised beams 14a,14b. Each of the polarised beams 14a,14b is incident on a steering prism 16a,16b which directs the polarised beam 14a,14b to a fibre-lens coupling 18 and into an optical fibre 20 for transmission of the polarised beam 14a,14b to the distal end of the respective optic fibre 20.

Control of the laser beam 12 which exits the laser source 10 is achieved by the reflection 22a,22b of a portion of each incident polarised beam 14a,14b onto a photodiode 24a,24b. The reflection occurs at the incident face of the steering prisms 16a,16b. A photodiode 24a,24b lies in each reflected beam path 22a,22b. The intensity of the reflected beams 22a,22b measured by the photodiodes 24a,24b is compared in electronics 26 and if they are not equal a signal 28 is sent to a heater driver 30 which provides power to heater coils 32. This changes the length of the laser tube and thus the frequency 34 of the laser beam 12.

The readings taken from the photodiodes 24a,24b are affected by stray light which has been back-scattered 36 from other components in the fibre optic system. This results in the heater driver 30 compensating for differences in the intensity of the polarised beams 14a,14b which do not exist. Thus, the laser may be destabilised by the mechanism which is designed to stabilise it.

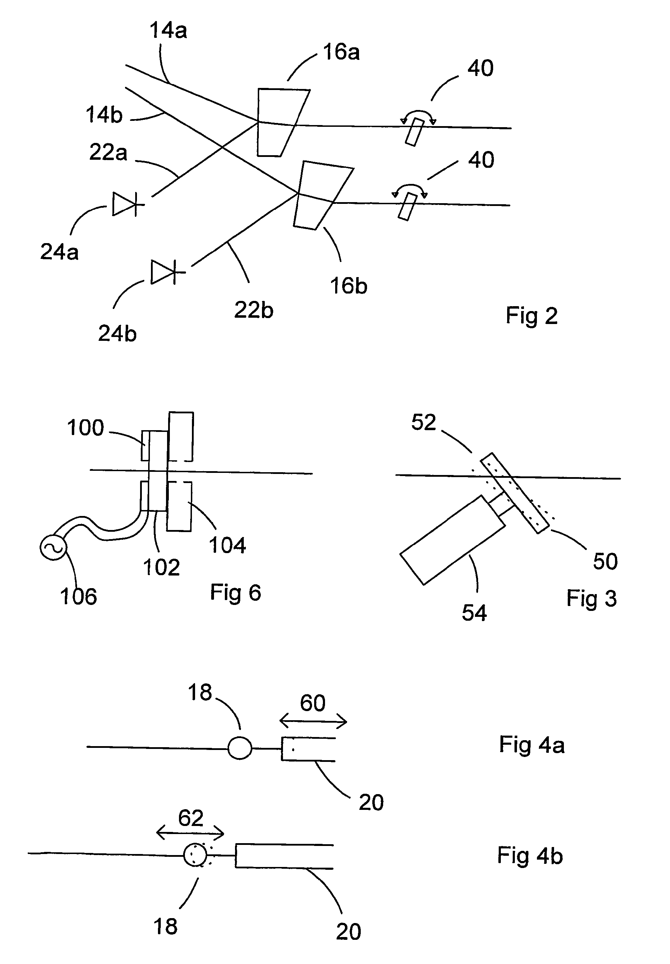

Fig 2 shows a phase modulator 40 according to the invention. The phase modulator 40 is an object which modulates, or alters the phase of light which passes through it. The phase modulator 40 is a glass block which oscillates within the polarised beam path 14a,14b over a small angular range, such as between 10° and 25°. This oscillation causes the phase of the light passing through the block to be altered. Due to the oscillation of the block, the change in phase of the light as it encounters the block is modulated in a time dependent manner i.e. the amount of change in phase is dependent on where the block is in its cycle of motion when the light passes through it.

The glass block 40 is located in the beam path after the polarised beams are incident on a beam steering prism 16a,16b. This is not essential, the glass block could alternatively be located at the exit of the laser source prior to polarisation of the laser beam by the birefringent prism 15.

The angular range of oscillation is a function of both the thickness of the glass block and the amount of phase change required. In order to achieve effective reduction in back-scattered light affecting the stabilisation of the laser, a phase change of nΠ radians (where n is an integer) should be achieved. A phase change of less than Π will reduce the back-scattered effect but may not achieve the required effect. It is preferred that the phase of the back-scattered light is altered by several multiples of Π so that the net residual phase shift from not achieving exactly nΠ is negligible.

The light beams 14a,14b after passing through the phase modulator 40 continue along their beams paths until they are coupled to optical fibres or manipulated in the desired manner such as by a plane mirror, lens or other component.

If the beams are coupled into an optical fibre, they are focused by a lens. There is a variation in coupling efficiency due to changes in displacement of the beams caused by the motion of the glass block. In order to ensure adequate coupling efficiency over the range of displacement, the glass block 40 must be sufficiently thin that the maximum displacement caused is within acceptable coupling efficiency limits but thick enough to produce the required phase shift.

Fig 3 shows an alternative phase modulator 50. In this case, the phase modulator 50 is a glass block which is offset (not normal) to both the beam path and its axis of rotation causing a cyclic variation 52 in the position of the glass block in the beam path. The glass block is rotated or oscillated by a motor 54.

Figs 4a and 4b show alternative embodiments of the invention. In these examples, rather than adding a rotating element to the system, the phase difference is introduced by moving 60,62 either the fibre 20 or the fibre-lens coupling 18 as shown in Figs 4a and 4b respectively. The distance of motion required is of the order of 0.15 microns for light of 633nm wavelength and is, as previously described, cyclic in nature. As an alternative to physically moving the end of the fibre 20, the length of the fibre may be changed in a periodic manner by the use of a piezoelectric element located near the end of the fibre. By connecting the piezoelectric element to an alternating voltage source, the length of the piezoelectric element changes cyclically at the frequency of the alternating voltage. Another embodiment uses Fresnel drag effect to phase modulate the light. One way to achieve this is to place a glass block longitudinally in the beam path and move it back and forth within the beam path.

The phase modulator will modulate all light that passes through it. This means that back-scattered light is modulated twice - on both the incident and back-scattered journeys - and, that the remainder of the laser beams (the parts that are not back-scattered) are modulated once. By carefully choosing the frequency of the movement of the phase modulator and the maximum path length change introduced by this modulator, the effect of the back-scattered light can be mitigated whilst the error introduced by the modulator on the frequency of the laser is minimised below the levels of error that are already present in the system i.e. a negligible increase in system error results.

If a 1mm thick glass block 40 having an angular range of motion of 20° were rotated at a frequency of 1kHz, then the frequency of the laser beam is altered by the order of 0.001ppm but, typical system errors in a vacuum are 0.01ppm and in air 1ppm, so the introduced frequency error is negligible.

The back-scattered light interferes with the laser beams 14a,14b (which, as discussed above, does not significantly reduce the accuracy of the system) and more importantly with the reference portion 22a,22b of each beam. However, the effect of this phase modulation of the back-scattered light on its interaction with and influence on the frequency stabilisation means (Fig 1, heater driver 30 which controls heater coils 32) is significant. The thermal response time of the heater driver and so heater coils is slower than the phase change of the back-scattered light so, in effect, it acts like a low frequency bandpass filter. The phase of the back-scattered light changes too quickly for the heater driver to respond and so it is ignored by the driver. If a different frequency stabilisation means is used, or a heater driver with a faster response time, then a separate low frequency bandpass filter may be used. This would be placed in the circuit between the intensity measurement means and the device which responds to a difference in intensity measurement, in this case the heater driver.

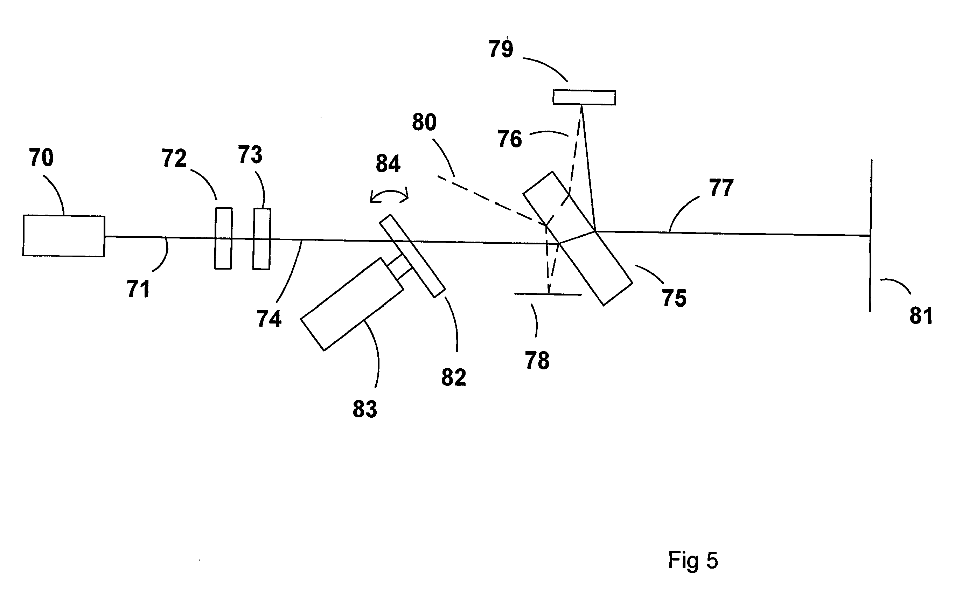

Fig 5 shows a laser interferometer having a laser source 70 which provides a dual frequency laser beam 71. A polaroid 72 blocks one of the frequency (and thus polarisation) modes from continuing along the laser beam path 74. Together with a quarter wave plate 73, the polaroid 72 forms an optical isolator which prevents back-scattered light from returning to the laser source and causing destabilisation thereof. The polarised single frequency laser beam 74 encounters a "non-polarising" plate beamsplitter 75, which splits the polarised laser beam 74 into a reference beam 76 and a measurement beam 77 (the reference beam 76 is shown as a dotted line for clarity).

The reference beam 76 is formed as a reflection on the first face of the "non-polarising" plate beamsplitter 75, it is reflected by a plane mirror 78 back towards the "non-polarising" plate beamsplitter 75. A proportion of the reference beam is transmitted through the "non-polarising" plate beamsplitter 75 onto a spatial fringe detector 79, the remainder is reflected 80 by the "non-polarising" plate beamsplitter 75. This reflected beam 80 is, in effect, back-scattered light so, the system is ideally arranged so that this stray light is not directed back towards the laser source 70.

The measurement beam 77 is formed from the light which is transmitted through the "non-polarising" plate beamsplitter 75. This measurement beam 77 is reflected by a plane mirror 81 (which could, alternatively be a retroreflector). When the reflected measurement beam re-encounters the "non-polarising" plate beamsplitter 75, a portion, which is reflected is directed towards the spatial fringe detector 79. The remaining light is transmitted back through the "non-polarising" plate beamsplitter 75 towards the laser source 70. It is this reflected light that necessitates the optical isolator 72,73. Unfortunately, the optical isolator 72,73 is not perfect thus it allows some of this back-scattered light through to the laser source 70. It is not perfect for several reasons including imperfections in the isolator optics themselves and because "non-polarising" beamsplitters are partially polarising. For this reason, a phase modulator is provided. The phase modulator is a glass block 82 which lies obliquely to the laser beam and is rotated by a motor 83. As the glass block 82 is also offset to its axis of rotation, the motor 83 moves 84 the glass block 82 within the beam path cyclically varying the path length of the beam and thus modulating the phase of the beam.

Fig 6 shows a further phase modulator. A piezoelectric element 100 is connected to a glass block 102 which is attached to a support 104. Both the piezoelectric element 100 and the support 104 have co-linear apertures which enable the passage of a laser beam through the glass block 102. The piezoelectric element 100 is electrically connected to an alternating voltage supply 106 which cyclically compresses the glass block 102 modulating the phase of light which passes through.

A further alternative phase modulator is a glass block with an applied varying voltage which produces a change in the refractive index of the glass. The person skilled in the art will appreciate that the inventive concept disclosed herein may be achieved by forms of phase modulation other than those specifically described however, any modulator which can impose a cyclically changing path length into the beam path is suitable for this purpose.

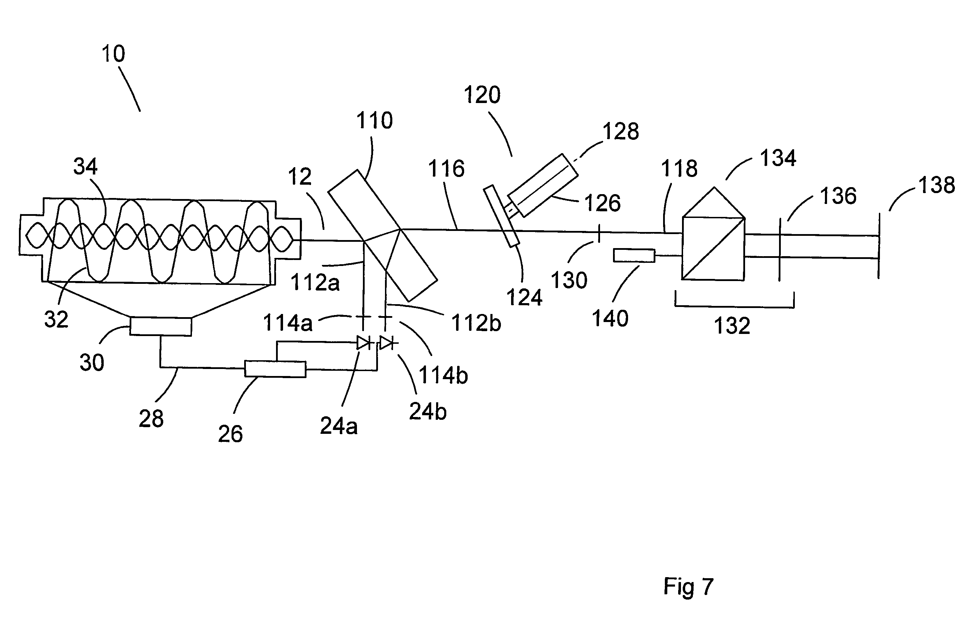

Fig 7 shows a laser interferometer according to the invention. A dual frequency laser beam 12 from a laser source 10 is incident on a "non-polarising" plate beamsplitter 110. A sub-beam 112a,112b is reflected from each face of the plate beamsplitter 110 and passes through a Polaroid 114a,114b respectively. The two Polariods 114a,114b each select a different polarisation state (and so frequency) of the sub-beams which are then incident on individual photodiodes 24a,24b. The stability of the laser is controlled by electronics 26 which compare the signal strengths received from the two photodiodes 24a,24b and signal 28 to a heater driver 30 if they are not equal (this is described in more detail with respect to Fig 1).

The laser beam 116 which passes through the plate beamsplitter 110 passes through a third Polaroid 130 which blocks one of the frequency modes of the laser beam. This polarised beam 118 is incident on an imperfect optical isolator 132 which comprises a polarising cubic beam splitter 134 and a quarter wave plate 136. The polarising beamsplitter 132 splits the incident polarised beam 118 into reference and measuring beams and subsequently recombines them after the measurement beam has been reflected by a plane mirror 138. The recombined beam is an interference beam which is detected by detector 140.

Light is back-scattered by various optical components such as the plane mirror 138 and the imperfect optical isolator 132. This light would normally affect the readings taken from the photodiodes 24a,24b and cause destabilise the laser however, a phase modulator 120 has been provided to prevent this.

The phase modulator 120 comprises a glass block 124 which is rotated or oscillated by a motor 126. The glass block 124 is mounted at an angle to the axis of rotation 128 of the motor 126 to produce the cyclic variation of phase shift in the back-scattered light.

The phase shift caused by phase modulators according to the invention is cyclic in nature.

## Claims

1. A laser system comprising
a laser source (10,70) for producing a laser beam (12,71) along a beam path;
frequency stabilisation means (26,28,30) which receives light diverted out of the beam path to stabilise the frequency of the laser beam;
at least one optical component (20,75) in the beam path which produces back-scattered light when in use;
a phase modulator (40,50,60,62,82) in the beam path for modulating the phase of the back-scattered light in order to reduce the effect of the back-scattered light on the frequency stabilisation means, **characterised in that** the phase modulator imposes a cyclically changing path length into the beam path.

2. A laser system according to claim 1, wherein the optical component is a plane mirror.

3. A laser system according to claim 1, wherein the optical component is an optical fibre (20).

4. A laser system according to any preceding claim, wherein the phase modulator is an oscillating glass block (50, 82).

5. A laser system according to claim 4, wherein the oscillation of the glass block is driven by a motor (54, 83).

6. A laser system according to claim 4 or claim 5, wherein the glass block (50,82) is not normal to the beam path.

7. A laser system according to claim 5, wherein the glass block is mounted at an angle to the axis of rotation of the motor.

8. A laser system according to claim 1, wherein the phase modulator is a glass block cyclically compressed by a piezoelectric element.

## Patentansprüche

1. Lasersystem, umfassend:
eine Laserquelle (10, 70) zur Erzeugung eines Laserstrahls (12, 71) entlang eines Strahlpfades;
ein Frequenzstabilisierungsmittel (26, 28, 30), das aus dem Strahlpfad umgelenktes Licht empfängt, um die Frequenz des Laserstrahls zu stabilisieren;
zumindest eine optische Komponente (20, 75) in dem Strahlpfad, die im Gebrauch rückgestreutes Licht erzeugt;
einen Phasenmodulator (40, 50, 60, 62, 82) in dem Strahlpfad zum Modulieren der Phase des rückgestreuten Lichts, um die Wirkung des rückgestreuten Lichts auf das Frequenzstabilisierungsmittel zu reduzieren, **dadurch gekennzeichnet, dass** der Phasenmodulator eine sich zyklisch ändernde Pfadlänge in den Strahlpfad einführt.

2. Lasersystem nach Anspruch 1, wobei die optische Komponente ein ebener Spiegel ist.

3. Lasersystem nach Anspruch 1, wobei die optische Komponente eine optische Faser (20) ist.

4. Lasersystem nach einem der vorhergehenden Ansprüche, wobei der Phasenmodulator ein oszillierender Glasblock (50, 82) ist.

5. Lasersystem nach Anspruch 4, wobei die Oszillation des Glasblocks durch einen Motor (54, 83) angetrieben wird.

6. Lasersystem nach einem der Ansprüche 4 oder 5, wobei der Glasblock (50, 82) nicht normal zu dem Strahlpfad angeordnet ist.

7. Lasersystem nach Anspruch 5, wobei der Glasblock unter einem Winkel zu der Rotationsachse des Motors montiert ist.

8. Lasersystem nach Anspruch 1, wobei der Phasenmodulator ein Glasblock ist, der zyklisch durch ein piezoelektrisches Element komprimiert wird.

## Revendications

1. Système laser comprenant
une source lumineuse (10,70) servant à produire un faisceau lumineux (12,71) le long d'une trajectoire de faisceau ;
un moyen de stabilisation de fréquence (26,28,30) qui reçoit de la lumière déviée vers l'extérieur de la trajectoire du faisceau afin de stabiliser la fréquence du faisceau laser ;
au moins un composant optique (20, 75) dans le faisceau laser qui produit de la lumière rétrodiffusée pendant l'utilisation ;
un modulateur de phase (40,50,60,62,82) dans le faisceau laser qui sert à moduler la phase de la lumière rétrodiffusée afin de réduire l'effet de la lumière rétrodiffusée sur le moyen de stabilisation de fréquence, **caractérisé en ce que** le modulateur de phase impose une longueur de trajectoire à changements cycliques dans la trajectoire du faisceau.

2. Système laser selon la revendication 1, dans lequel le composant optique est un miroir plan.

3. Système laser selon la revendication 1, dans lequel le composant optique est une fibre optique (20).

4. Système laser selon l'une quelconque des revendications précédentes, dans lequel le modulateur de phase est un bloc de verre oscillant (50,82).

5. Système laser selon la revendication 4, dans lequel l'oscillation du bloc de verre est entraînée par un moteur (54,83).

6. Système laser selon la revendication 4 ou 5, dans lequel le bloc de verre (50, 82) n'est pas normal à la trajectoire du faisceau.

7. Système laser selon la revendication 5, dans lequel le bloc de verre est monté à un angle de l'axe de rotation du moteur.

8. Système laser selon la revendication 1, dans lequel le modulateur de phase est un bloc de verre comprimé cycliquement par un élément piézoélectrique.
